# EUROPEAN PATENT APPLICATION

(11) **EP 1 117 137 A2**
(43) Date of publication of application: **18.07.2001**
(21) Application number: 01100752.3
(22) Date of filing: 12.01.2001
(51) Int. Cl.: H01L 51/20

(54) **Photoelectric conversion device**

(30) Priority: 14.01.2000 JP 2000006969; 10.03.2000 JP 2000067299
(71) Applicant: FUJI PHOTO FILM CO., LTD., Kanagawa (JP)
(72) Inventor: Nakamura, Shigeru, Minami-Ashigara-shi, Kanagawa (JP); Kubota, Tadahiko, Minami-Ashigara-shi, Kanagawa (JP); Asami, Masahiro, Minami-Ashigara-shi, Kanagawa (JP); Konno, Akinori, Hamamatsu-shi, Shizuoka (JP)
(74) Representative: Grünecker, Kinkeldey, Stockmair & Schwanhäusser Anwaltssozietät

(57) **Abstract**

A photoelectric conversion device comprising an electrically conductive support, a photosensitive layer containing a semiconductor having a dye adsorbed thereby, a positive hole-transporting layer containing a positive hole-transporting material and a counter electrode, wherein said positive hole-transporting layer is prepared by electrolysis.

## Description

### FIELD OF THE INVENTION

This invention relates to a photoelectric conversion device comprising a dye-sensitized semiconductor, a photo cell and a solar cell module comprising the photoelectric conversion device, and a method for producing the photoelectric conversion device.

### BACKGROUND OF THE INVENTION

In the field of photovoltaic power generation, the focus of research and development and practical application has been chiefly put on monocrystalline silicon solar cells, polycrystalline silicon solar cells, amorphous silicon solar cells, and compound solar cells using cadmium telluride, copper indium selenide, etc. It is required for spread of solar cells to overcome such difficulties as a high production cost, a short supply of raw materials, and a long energy payback time. Although many solar cells using organic materials have been proposed aiming at an increase of working area and a reduction of cost, they have a low conversion efficiency and poor durability.

Under these circumstances, *Nature,* vol. 353, pp. 737-740 (1991) and U.S. Patent 4,927,721 disclose a photoelectric conversion device using dye-sensitized semiconductor particles, a solar cell comprising the device, and materials and techniques for producing them. The proposed cell is a wet type solar cell comprising, as a work electrode, a porous thin film of titanium dioxide spectrally sensitized by a ruthenium complex. A primary advantage of this system is that such an inexpensive oxide semiconductor as titanium dioxide can be used without being highly purified so that a photoelectric conversion device can be supplied at a competitive price. A secondary advantage is that the sensitizing dye used shows a broad absorption spectrum so that substantially the whole range of visible light can be converted to electricity.

However, since the device is of wet type in which an electrical connection to the counter electrode is made by an electrolytic solution, there is a fear that the device will be short of the electrolytic solution due to evaporation in long-term use only to have a seriously deteriorated photoelectric conversion efficiency or fail to function as a device.

To prevent shortage of an electrolytic solution in a wet type solar cell, J. *Phys. D: Appl*. *Phys.,* vol. 31, pp. 1492-1496 (1998) and *Chem. Mater.,* vol. 10, pp. 1501-1509 (1998) propose solid state photoelectric conversion devices using inorganic positive hole-transporting materials such as CuI and CuSCN. As a result of investigation, however, photoelectric conversion devices using these positive hole-transporting materials turned out to have a very small short-circuit current (J_{SC}) or undergo noticeable deterioration in photoelectric conversion characteristics, such as a short-circuit current, in several days.

### SUMMARY OF THE INVENTION

An object of the present invention is to provide a dye-sensitized photoelectric conversion device and a photo cell, particularly a solar cell, having a high short-circuit current, a high photoelectric conversion efficiency, and excellent durability.

Another object of the invention is to provide a method for producing such a photoelectric conversion device and a photo cell.

The objects of the invention are accomplished by the following inventions and its preferred embodiments.
(1) A photoelectric conversion device comprising an electrically conductive support, a photosensitive layer containing a semiconductor having a dye adsorbed thereby, a positive hole-transporting layer containing a positive hole-transporting material, and a counter electrode, wherein said positive hole-transporting layer is prepared by electrolysis.
(2) The photoelectric conversion device of item (1) above, wherein said semiconductor is a porous semiconductor.
(3) The photoelectric conversion device of item (1) or (2) above, wherein said electrolysis is a method of forming said positive hole-transporting layer on said photosensitive layer by electrolysis while irradiating said semiconductor having a dye adsorbed thereby with light
(4) The photoelectric conversion device of item (3) above, wherein said light has a wavelength at which said dye shows absorption.
(5) The photoelectric conversion device of item (3) or (4) above, wherein said irradiating is from the side of said electrically conductive support.
(6) The photoelectric conversion device of any one of items (1) to (5) above, wherein said electrolysis is constant-current electrolysis.
(7) The photoelectric conversion device of any one of items (1) to (5) above, wherein said electrolysis is controlled potential electrolysis.
(8) The photoelectric conversion device of any one of items (1) to (7) above, wherein the potential of said electrolysis is -2 to 15 V with reference to a silver/silver chloride reference electrode.
(9) The photoelectric conversion device of any one of items (1) to (8) above, wherein said electrolysis is at a current density of 0.1 to 500 mA/cm².
(10) The photoelectric conversion device of any one of items (1) to (9) above, wherein said positive hole-transporting material mainly contains a p-type semiconductor.
(11) The photoelectric conversion device of item (10) above, wherein said p-type semiconductor has a band gap of 2 eV or more.
(12) The photoelectric conversion device of item (10) or (11) above, wherein said p-type semiconductor has an ionization potential of 4.5 to 5.5 eV.
(13) The photoelectric conversion device of any one of items (10) to (12) above, wherein said p-type semiconductor is a compound semiconductor containing monovalent copper.
(14) The photoelectric conversion device of item (13) above, wherein said compound semiconductor containing monovalent copper contains at least one of CuI and CuSCN.
(15) The photoelectric conversion device of any one of items (1) to (14) above, wherein said semiconductor of said photosensitive layer has a specific surface area of 1 to 150 m²/g.
(16) The photoelectric conversion device of any one of items (1) to (14) above, wherein said semiconductor of said photosensitive layer has a specific surface area of 20 to 100 m²/g.
(17) The photoelectric conversion device of any one of items (1) to (16) above, which has an undercoat containing an oxide semiconductor between said electrically conductive support and said photosensitive layer.
(18) The photoelectric conversion device of item (17) above, wherein said oxide semiconductor is a titanium dioxide.
(19) The photoelectric conversion device of any one of items (1) to (18) above, wherein said dye is a ruthenium complex dye or a methine dye.
(20) The photoelectric conversion device of any one of items (1) to (19) above, wherein said semiconductor of said photosensitive layer is constituted by titanium dioxide particles.
(21) A photo cell comprising the photoelectric conversion device of any one of items (1) to (20) above.
(22) A solar cell module comprising the photoelectric conversion device of any one of items (1) to (20) above.
(23) A method for producing a photoelectric conversion device comprising an electrically conductive support, a photosensitive layer comprising a semiconductor having a dye adsorbed thereby, a positive hole-transporting layer comprising a positive hole-transporting material, and a counter electrode, which method comprises forming said positive hole-transporting layer on said photosensitive layer by electrolysis while irradiating said photosensitive layer with light.

### BRIEF DESCRIPTION OF THE DRAWINGS

Fig. 1 is a partial cross section showing the basic structure of a photoelectric conversion device.

Figs. 2 through 9 illustrate preferred modifications of the basic structure of Fig. 1.

Fig. 10 is a partial cross section of a substrate-integrated type solar cell module in which the photoelectric conversion device of the invention is used.

### DETAILED DESCRIPTION OF THE INVENTION

### [I] Photoelectric Conversion Device

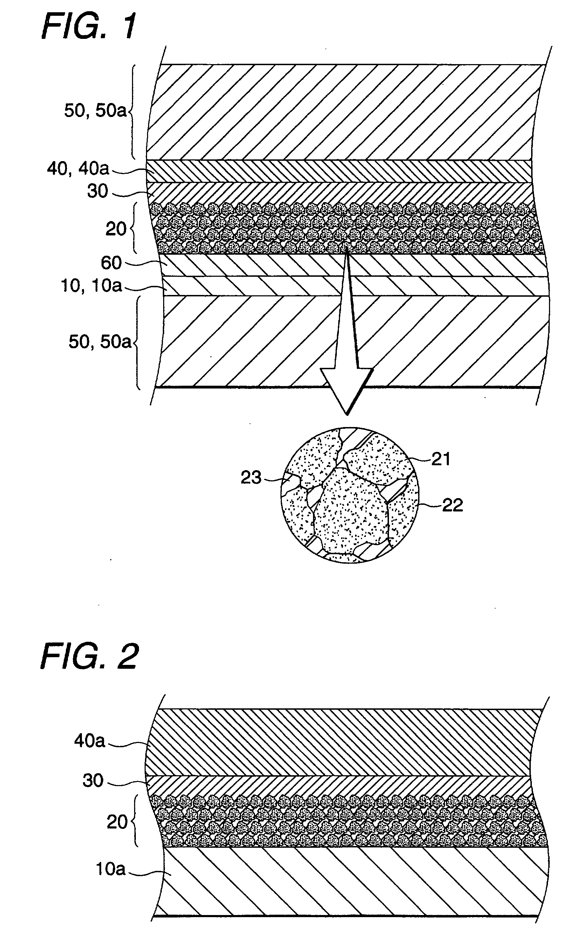

The photoelectric conversion device according to the invention comprises an electrically conductive support, a photosensitive layer comprising a semiconductor having a dye adsorbed thereby, a positive hole-transporting layer, and a counter electrode. The electrically conductive support and the photosensitive layer make up a dye-sensitized semiconductor electrode, i.e., a work electrode. A preferred embodiment of the photoelectric conversion device is shown in Fig. 1, in which an electrically conductive layer 10, an undercoat 60, a photosensitive layer 20, a positive hole-transporting layer 30, and an electrically conductive layer 40 (hereinafter referred to as a counter electrode electrically conductive layer) are built up in this order. The photosensitive layer 20 is made of semiconductor particles 21 which are sensitized with a dye 22 and a positive hole-transporting material 23 that has penetrated from the positive hole-transporting layer 30 into the gaps among the semiconductor particles 21. The positive hole-transporting material 23 is the same as the material forming the positive hole-transporting layer 30. A substrate 50 may be provided on the electrically conductive layer 10 and/or the counter electrode electrically conductive layer 40 to impart strength to the device. In what follows, the layer composed of the electrically conductive layer 10 and the substrate 50, which can be provided optionally, will be referred to as an electrically conductive support, and the layer composed of the counter electrode electrically conductive layer 40 and the substrate 50, which can be provided optionally, will be referred to as a counter electrode. The photoelectric conversion device connected to an external circuit to do work is a photo cell. In Fig. 1, the conducive layer 10, the counter electrode electrically conductive layer 40, and the substrates 50 may be a transparent electrically conductive layer 10a, a transparent counter electrode electrically conductive layer 40a, and transparent substrates 50a, respectively.

Light having entered the photosensitive layer 20 comprising the dye 22-sensitized semiconductor particles 21 excites the dye 22, etc. The excited dye, etc. have high energy electrons, which are handed over from the dye 22, etc. to the conduction band of the semiconductor particles 21 and diffused to reach the electrically conductive layer 10. In this situation, the molecules of the dye 22, etc. are in an oxidized state as a result the electron migration. In a photo cell, the electrons in the electrically conductive layer 10 work in the external circuit and return to the oxidized dye 22, etc. through the counter electrode electrically conductive layer 40 and the positive hole-transporting layer 30, thereby regenerating the dye 22. The photosensitive layer 20 acts as a negative electrode of the cell. The components constituting the individual layers may be diffused and mixed mutually at their boundaries, for example, the boundary between the conductor layer 10 and the photosensitive layer 20, the boundary between the photosensitive layer 20 and the positive hole-transporting layer 30, and the boundary between the positive hole-transporting layer 30 and the counter electrode electrically conductive layer 40.

### (A) Positive Hole-Transporting Layer

The positive hole-transporting layer performs a function for rapidly reducing the oxidized dye and for transporting the positive holes, injected through the interface with the dye, to the counter electrode. The positive hole-transporting layer comprises a positive hole-transporting material. The positive hole-transporting material preferably comprises a p-type semiconductor, particularly a p-type compound semiconductor, as a main component. It is preferred for the p-type semiconductor to have a band gap of 2 eV or more, particularly 2.5 eV or more. In order to reduce the dye holes, it is necessary for the semiconductor to have an ionization potential smaller than that of the dye-sensitized electrode. While a preferred range of the ionization potential of the p-type semiconductor used in the positive hole-transporting layer varies depending on the sensitizing dye used, it is usually 4.5 to 5.5 eV, particularly 4.7 to 5.3 eV. The p-type semiconductor is preferably of an inorganic compound, such as a compound semiconductor containing monovalent copper, GaP, NiO, CoO, FeO, Bi₂O₃, MoO₂, and Cr₂O₃. Preferred of them is a compound semiconductor containing monovalent copper.

Compound semiconductors containing monovalent copper, which is used in the invention for preference, include CuI, CuSCN, CuInSe₂, Cu(In,Ga)Se₂, CuGaSe₂, Cu₂O, CuS, CuGaS₂, CuInS₂, and CuAlSe₂, with CuI and CuSCN being preferred. CuI is the most preferred. It is preferred for the compound semiconductor containing monovalent copper to have a large band gap so as not to interfere with dye absorption.

The positive hole-transporting layer comprising a compound semiconductor containing CuI preferably has a hole mobility of 10⁻⁴ cm²/V·sec or more and less than 10⁴ cm²/V·sec., particularly 10⁻³ cm²/V·sec or more and less than 10³ cm²/V·sec. The positive hole-transporting layer of the invention preferably has an electrical conductivity of 10⁻⁸ S/cm or higher and lower than 10² S/cm, particularly 10⁻⁶ S/cm or higher and lower than 10 S/cm. The positive hole-transporting layer preferably has a thickness (a thickness above the particulate semiconductor-containing layer) of 0.005 µm or greater and smaller than 100 µm, particularly 0.01 µm or greater and smaller than 50 µm.

The positive hole-transporting layer is formed on the photosensitive layer by electrolysis. The positive hole-transporting layer may be formed on the photosensitive layer by electrolysis while irradiating the photosensitive layer (i.e., the semiconductor having a dye adsorbed thereby) with light. The term "electrolysis" as used herein denotes a method in which a plate electrode is placed in a solution, and a direct voltage is applied thereto to deposit a substance thereon. It is considered that the positive hole-transporting layer formed by this method establishes a proper contact with the particulate semiconductor and the adsorbed dye thereby facilitating efficient donation and acceptance of positive holes.

The electrolysis can be carried out by using the dye-sensitized particulate semiconductor-containing layer formed on the electrically conductive support as a work electrode in accordance with a common method described, e.g., in *Denkikagaku Sokuteiho* published by Gihodo. A constant-current method and a controlled potential method are preferably adopted.

The solution to be electrolyzed, i.e., an electrolytic solution, is a solution of a charge transporting material, such as copper (I) iodide that is preferably used in the invention, and copper thiocyanate, in a solvent. Preferred solvents for CuI include cyano-containing solvents (e.g., acetonitrile or methoxyacetonitrile), acetone, ether, and water, still preferably acetone or acetonitrile. An alkali metal halide (e.g., potassium iodide), ammonia, etc. is preferably added to the solvent as a complexing agent. The solution can further contain CuBr, CuCl, etc. The solution can furthermore contain cresolsulfonic acid, acetic acid, thiourea, dextrin, and so forth as additives. The electrolytic solution described in *Journal of Photochemistry and Photobiology A: Chemistry*, vol. 91, pp. 59-61 (1995), i.e., a solution of 0.2 g of copper (I) iodide and 0.5 g of potassium iodide in 30 ml of acetone, can be mentioned as an example. In using copper thiocyanate as a charge transporting material, ether is preferably used as a solvent, and an alkali metal thiocyanate or ammonia is preferably used as a complexing agent.

The counter electrode to be used in the electrolysis is not limited as far as it allows electric current to flow in the direction opposite to that induced in the work electrode and it does not undergo any reaction during electrolysis. A preferred counter electrode is platinum or carbon. The reference electrode described in *Denkikagaku Sokuteiho* published by Gihodo can be used.

The potential between the work electrode and the reference electrode, e.g., a silver/silver chloride reference electrode, is preferably -2 to 15 V, still preferably -1 to 10 V, particularly preferably -1 to 6 V, and especially preferably 0 to 5 V. The current density of the work electrode is preferably 0.1 to 500 mA/cm², still preferably 1 to 200 mA/cm², particularly preferably 15 to 100 mA/cm².

The wavelength range of the light with which the photosensitive layer is irradiated during the formation of the positive hole-transporting layer should include at least a part or the whole of the range of from 300 to 1000 nm. Light having a wavelength at which the dye of the photosensitive layer shows absorption is preferred. The irradiation intensity is preferably 10 to 500 mW/cm², still preferably 50 to 400 mW/cm², particularly preferably 50 to 300 mW/cm². Light may be applied directly on the dye-containing photosensitive layer but is preferably applied from the side of its electrically conductive support.

### (B) Electrically Conductive Support

The electrically conductive support is (1) a single electrically conductive layer or (2) a combination of an electrically conductive layer and a substrate. As long as the electrically conductive layer has sufficient strength and tight sealing properties, the substrate is not always necessary.

In the case (1), a material having sufficient strength and electrical conductivity, such as metal, is used as the electrically conductive layer.

In the case (2), a substrate having an electrically conductive layer containing a conducting agent on the photosensitive layer side is used. Preferred conducting agents include metals (e.g., platinum, gold, silver, copper, aluminum, rhodium, and indium), carbon, and electrically conductive metal oxides (e.g., indium tin oxide and Fluorine-doped tin oxide). The electrically conductive layer preferably has a thickness of about 0.02 to 10 µm.

The electrically conductive support preferably has as low a surface resistivity as possible. A desirable surface resistivity is 100 Ω/square or smaller, particularly 40 Ω/square or smaller. While not limiting, the practical minimal surface resistivity is about 0.1 Ω/square.

Where light is incident upon the electrically conductive support side of the photoelectric conversion device, it is preferred that the electrically conductive support be substantially transparent to light. The term "substantially transparent" is intended to mean that the light transmission is at least 10%, preferably 50% or more, still preferably 70% or more.

A preferred transparent electrically conductive support is a transparent glass or plastic substrate having formed thereon a transparent electrically conductive layer comprising an electrically conductive metal oxide by application or vacuum deposition or a like technique. In particular, electrically conductive glass obtained by depositing Fluorine-doped tin dioxide on inexpensive soda-lime float glass is preferred. For the manufacture of inexpensive flexible photoelectric conversion devices or solar cells, a transparent polymer film having the above-described electrically conductive layer is convenient. Useful transparent polymers include tetraacetylcellulose (TAC), polyethylene terephthalate (PET), polyethylene naphthalate (PEN), syndiotactic polystyrene (SPS), polyphenylene sulfide (PPS), polycarbonate (PC), polyacrylate (PAr), polysulfone (PSF), polyester sulfone (PES), polyether-imide (PEI), cyclic polyolefins, and brominated phenoxy resins. To secure sufficient transparency, the amount of the electrically conductive metal oxide is preferably 0.01 to 100 g per m² of the glass or plastic substrate.

In order to decrease the resistance of the transparent electrically conductive support, it is preferred to use metal leads, which are preferably made of aluminum, copper, silver, gold, platinum, nickel, etc., with an aluminum lead or a silver lead being particularly preferred. The metal lead is preferably formed on the transparent substrate by vacuum evaporation, sputtering or a like deposition technique, on which a transparent electrically conductive layer of Fluorine-doped tin oxide or ITO is provided. It is also preferred that the transparent electrically conductive layer be provided on the transparent substrate, on which the metal lead can be formed. Reduction in incident light quantity due to the metal leads is preferably within 10%, still preferably 1 to 5%.

### (C) Photosensitive Layer

In the photosensitive layer comprising a dye-sensitized semiconductor, the semiconductor acts as a so-called photoreceptor that absorbs light to separate charges to generate electrons and positive holes. In the dye-sensitized semiconductor, the task of light absorption and generation of electrons and holes is chiefly performed by the dye, and the semiconductor plays a role in accepting and transmitting the electrons.

### (1) Semiconductor

The semiconductor which can be used in the photosensitive layer includes element semiconductors, e.g., Si or Ge, and compound semiconductors, such as III-V element-containing compound semiconductors, metal chalcogenides (e.g., oxides, sulfides, and selenides), and perovskite semiconductors.

The metal chalcogenides preferably include an oxide of titanium, tin, zinc, iron, tungsten, zirconium, hafnium, strontium, indium, cerium, yttrium, lanthanum, vanadium, niobium or tantalum; a sulfide of cadmium, zinc, lead, silver, antimony or bismuth; a selenide of cadmium or lead; and cadmium telluride. The perovskite semiconductors include strontium titanate, calcium titanate, sodium titanate, barium titanate, and potassium niobate. Other compound semiconductors include a phosphide of zinc, gallium, indium or cadmium, gallium arsenide, copper indium selenide, and copper indium sulfide.

Examples of semiconductors preferred for use in the photosensitive layer include Si, TiO₂, SnO₂, Fe₂O₃, WO₃, ZnO, Nb₂O₅, CdS, ZnS, PbS, Bi₂S₃, CdSe, CdTe, GaP, InP, GaAs, CuInS₂, and CuInSe₂. Still preferred are TiO₂, ZnO, SnO₂, Fe₂O₃, WO₃, Nb₂O₅, CdS, PbS, CdSe, InP, GaAs, CuInS₂, and CuInSe₂. TiO₂ and Nb₂O₅ are particularly preferred. TiO₂ is the most preferred.

The semiconductor may be single crystalline or polycrystalline. A porous semiconductor film made of fine particles is particularly preferred. It is preferred for the porous semiconductor film has a specific surface area of 1 to 150 m²/g, particularly 5 to 120 m²/g, especially 20 to 100 m²/g. The semiconductor particles, which generally have a particle size on the order of nanometers to microns, preferably have an average primary particle size of 5 to 200 nm, particularly 8 to 100 nm, in terms of a projected area diameter. The semiconductor particles in a dispersed state (secondary particles) preferably have an average particle size of 0.01 to 100 µm.

Semiconductor particles of two or more kinds having different size distributions can be used as a mixture. In this case, the average size of smaller particles is preferably 5 nm or smaller. For the purpose of scattering incident light to improve the rate of capturing light, large semiconductor particles about 300 nm in size may be used in combination.

The particulate semiconductor is preferably prepared by a sol-gel method described, e.g., in Sumio Sakubana, *Sol-gel- hono kagaku*, Agune Shofusha (1988) and Gijutsu Joho Kyokai, *Sol-gel-ho niyoru hakumaku coating gijutsu* (1995), and a gel-sol method described in Tadao Sugimoto, *Materia,* vol. 35, No. 9, pp. 1012-1018, "Shin goseiho gel-sol-ho niyoru tanbunsan ryushino goseito size keitai seigyo" (1996). The method for preparing an oxide developed by Degussa AG which comprises pyrogenically hydrolyzing a metal chloride in an oxyhydrogen flame is also preferred.

For preparation of titanium oxide particles, a sulfuric acid method and a chlorine method described in Manabu Seino, *Sanka titan busseito ohyogijutu,* Gihodo (1997) are also employable for preference in addition to the above-described sol-gel method, gel-sol method and pyrogenic flame hydrolysis. Of the available sol-gel methods for preparing titanium oxide particles, particularly preferred are the method described in Barbe, et al, *Journal of American Ceramic Society,* vol. 80, No. 12, pp. 3157-3171 (1997) and the method described in Burnside, et al., *Chemical Materials,* vol. 10, No. 9, pp. 2419-2425.

### (2) Formation of Particulate Semiconductor Layer

The particulate semiconductor layer is formed on the electrically conductive support by, for example, a method comprising coating the electrically conductive support with a dispersion or colloidal solution of the semiconductor particles or the aforementioned sol-gel method, and the like. Film formation in a wet system is relatively advantageous, taking into consideration suitability to large-scale production of a photoelectric conversion device, controllability of liquid physical properties, and adaptability to various electrically conductive supports. Film formation in a wet system is typically carried out by application methods or printing methods.

A dispersion of the semiconductor particles is prepared by the above-mentioned sol-gel method, a method comprising grinding a semiconductor in a mortar, or a method comprising wet grinding a semiconductor in a mill. A synthetic semiconductor as precipitated in a solvent in the form of fine particles can also be used as such. Useful dispersing media include water and various organic solvents, such as methanol, ethanol, isopropyl alcohol, dichloromethane, acetone, acetonitrile, and ethyl acetate. In preparing a dispersion, a polymer (e.g., polyethylene glycol), a surface active agent, an acid, a chelating agent, and the like may be added as a dispersant if desired. In particular, use of polyethylene glycol with an appropriately controlled molecular weight is effective for forming a hardly peelable film or for modifying the viscosity of the dispersion.

Wet coating techniques include application methods such as roll coating and dip coating, metering methods such as air knife coating or blade coating, and application methods combined with metering such as wire bar coating (JP-B-58-4589), slide hopper coating (U.S. Patents 2,681,294, 2,761,419, and 2,761,791), extrusion coating, and curtain coating. General-purpose spin coating or spraying techniques are also suitable. Wet printing techniques include letterpress printing, offset printing, gravure printing, intaglio printing, rubber plate printing, and screen printing. A suitable film formation method is chosen from among the above-enumerated techniques in accordance with the liquid viscosity and a desired wet thickness.

The liquid viscosity is largely dependent on the kind and the dispersibility of the semiconductor particles, the solvent, and additives such as a surface active agent and a binder. In order to form a uniform film, extrusion coating or casting is fit for a high viscous liquid (e.g., 0.01 to 500 Poise), while slide hopper coating, wire bar coating or spin coating is suited for a low viscous liquid (e.g., 0.1 Poise or lower). A low viscous liquid could be applied by extrusion coating where it is to be applied to some coating weight. Thus, a suitable wet method for film formation can be selected in accordance with such parameters as the liquid viscosity, the coating weight, the type of the substrate, the speed of application, and so forth.

The semiconductor layer does not need to be a single layer. Two or more layers different in particle size of semiconductor particles, in kind of semiconductors or in composition as for the binder or additives can be provided. In case where single operation of application is insufficient for giving a desired thickness, multilayer coating is effective. Extrusion coating or slide hopper coating is suitable for multilayer coating. Multilayer coating can be carried out simultaneously or by successively repeating the coating operation several times or more than ten times. Screen printing is also preferably applicable to successive multilayer coating.

In general, as the thickness of the particulate semiconductor layer (i.e., photosensitive layer) increases, the amount of the dye held per unit projected area increases to show an increased rate of capturing light, but the distance of diffusion of generated electrons also increases, which results in an increased loss due to re-coupling of charges. Accordingly, there is a favorable thickness range for the particulate semiconductor layer, which is typically from 0.1 to 100 µm. Where the device is applied to a photo cell, a favorable thickness is 1 to 30 µm, particularly 2 to 25 µm. The coating weight of the semiconductor particles is preferably 0.5 to 400 g/m², still preferably 3 to 100 g/m².

It is preferred that the semiconductor particles applied to the electrically conductive support be heated to bring them into electronic contact with each other, to improve film strength, and to improve adhesion to the substrate. A preferred heating temperature is 40°C or higher and lower than 700°C, particularly from 100 to 600°C. The heating time is usually from about 10 minutes to about 10 hours. Where a substrate having a low melting point or a low softening point, such as a polymer film, is used, high-temperature treatment which would deteriorate the substrate should be avoided. For the economical consideration, too, the heating temperature is preferably as low as is consistent with the effect. The heating temperature could be lowered by using small semiconductor particles having a diameter of up to 5 nm in combination or by conducting the heat treatment in the presence of a mineral acid.

For the purpose of increasing the surface area of the semiconductor particles and of increasing the purity in the vicinities of the semiconductor particles thereby to improve electron injection efficiency from the dye to the semiconductor particles, the heat-treated particulate semiconductor layer can be subjected to chemical plating with a titanium tetrachloride aqueous solution or electrochemical plating with a titanium trichloride aqueous solution.

### (3) Dye

The dye which can be used in the photosensitive layer preferably includes metal complex dyes and methine dyes. Two or more kinds of dyes can be used in combination so as to broaden the wavelength region of photoelectric conversion and to increase the conversion efficiency. The dyes to be combined and their ratio can be selected in conformity with the wavelength region and the intensity distribution of a light source to be used.

It is preferred for the dyes to have an appropriate interlocking group for linking to the surface of the semiconductor particles. Preferred interlocking groups include -COOH, -OH, -SO₃H, a cyano group, -P(O) (OH)₂, -OP(O) (OH)₂, and chelating groups having pi conductivity, such as oxime, dioxime, hydroxyquinoline, salicylate and α-keto-enolate groups. Particularly preferred of them are -COOH, -P(O) (OH)₂, and -OP(O) (OH)₂. The interlocking group may be in the form of a salt with an alkali metal, etc. or an intramolecular salt. Where the methine chain of a polymethine dye has an acidic group as in the case where the methine chain forms a squarylium ring or a croconium ring, that moiety can serve as a interlocking group.

### (a) Metal Complex Dye

The metal complex dyes preferably include ruthenium complex dyes. Useful ruthenium complex dyes are described, e.g., in U.S. Patents 4,927,721, 4,684,537, 5,084,365, 5,350,644, 5,463,057, and 5,525,440, JP-A-7-249790, JP-W-10-504521, and W098/50393. Those represented by formula (I) are particularly preferred.

(A₁)ₚRu(B-a) (B-b) (B-c) (I)

wherein A₁ represents a ligand selected from Cl, SCN, H₂O, Br, I, CN, NCO and SeCN; p represents an integer of 0 to 3; and B-a, B-b, and B-c each represent an organic ligand selected from B-1 to B-8 shown below. 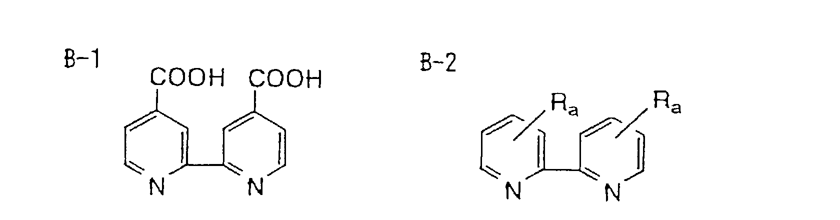 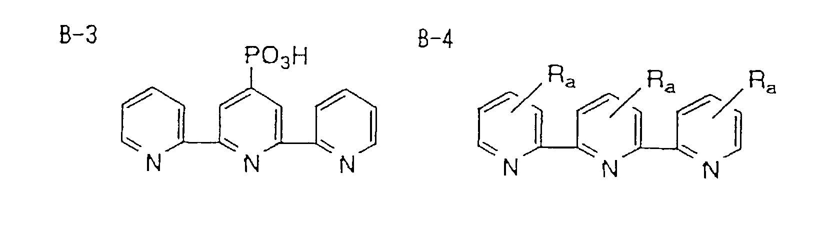 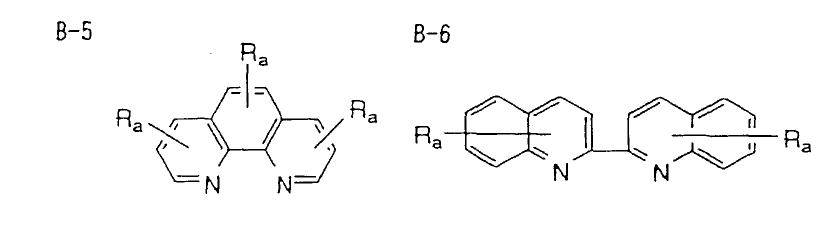 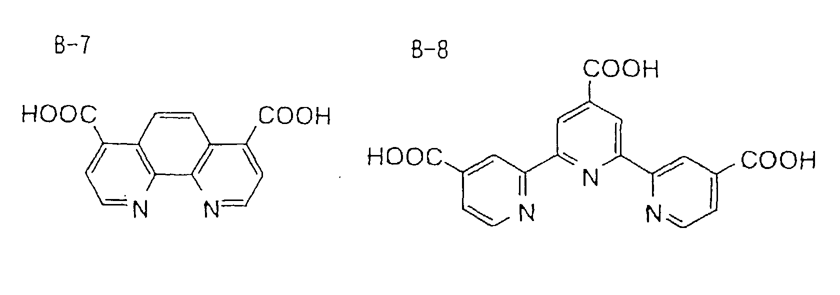 wherein Rₐ represents a hydrogen atom or a substitutent.

The substituent as Rₐ includes a halogen atom, a substituted or unsubstituted alkyl group having 1 to 12 carbon atoms, a substituted or unsubstituted aralkyl group having 7 to 12 carbon atoms, a substituted or unsubstituted aryl group having 6 to 12 carbon atoms, a carboxyl group, and a phosphoric acid group. The acid groups may be in a salt form. The alkyl group and the alkyl moiety of the aralkyl group may be either straight or branched, and the aryl group and the aryl moiety of the aralkyl group may be either monocyclic or polycyclic (condensed rings or independent rings). The organic ligands, B-a, B-b and B-c, may be the same or different. In other words, all the organic ligands may be B-a, or two ligands out of three may be either one of B-a and B-b with the rest being the other.

Specific examples of preferred ruthenium complex dyes represented by formula (I) are tabulated below.

| (A₁)ₚRu(B-a) (B-b) (B-c) | | | | | | |
|---|---|---|---|---|---|---|
| No. | A₁ | p | B-a | B-b | B-c | Rₐ |
| R-1 | SCN | 2 | B-1 | B-1 | - | - |
| R-2 | CN | 2 | B-1 | B-1 | - | - |
| R-3 | Cl | 2 | B-1 | B-1 | - | - |
| R-4 | CN | 2 | B-7 | B-7 | - | - |
| R-5 | SCN | 2 | B-7 | B-7 | - | - |
| R-6 | SCN | 2 | B-1 | B-2 | - | 4,4'-COO⁻N⁺(n-C₄H₉)₄ |
| R-7 | SCN | 1 | B-1 | B-3 | - | - |
| R-8 | Cl | 1 | B-1 | B-4 | - | H |
| R-9 | I | 2 | B-1 | B-5 | - | H |
| R-10 | SCN | 3 | B-8 | - | - | - |
| R-11 | CN | 3 | B-8 | - | - | - |
| R-12 | SCN. | 1 | B-8 | B-2 | - | 4,4'-COO⁻N⁺(n-C₄H₉)₄ |
| R-13 | - | 0 | B-1 | B-1 | B-1 | - |

Specific examples of other preferred metal complex dyes are shown below.

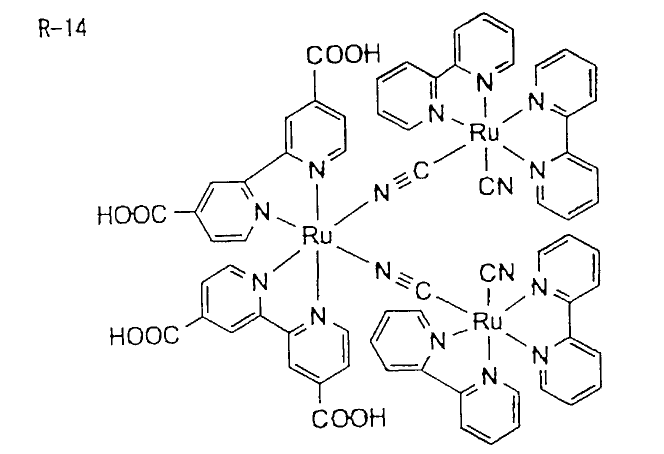

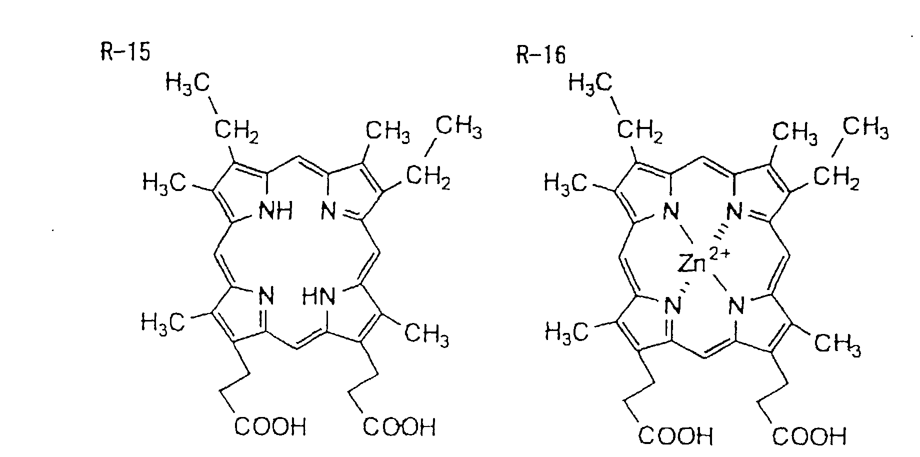

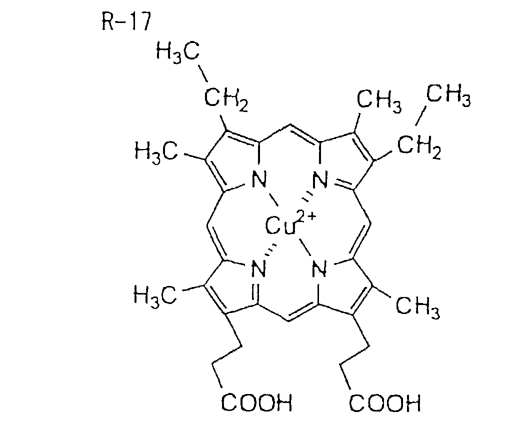

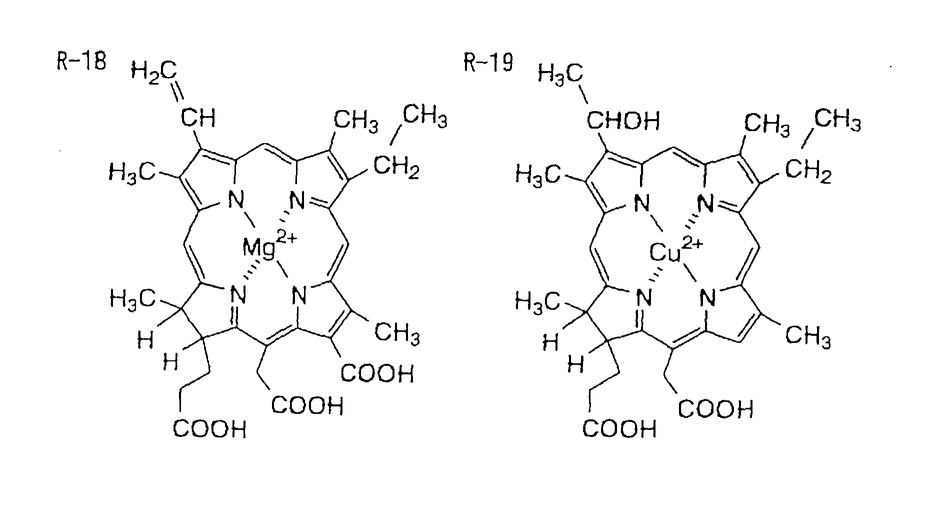

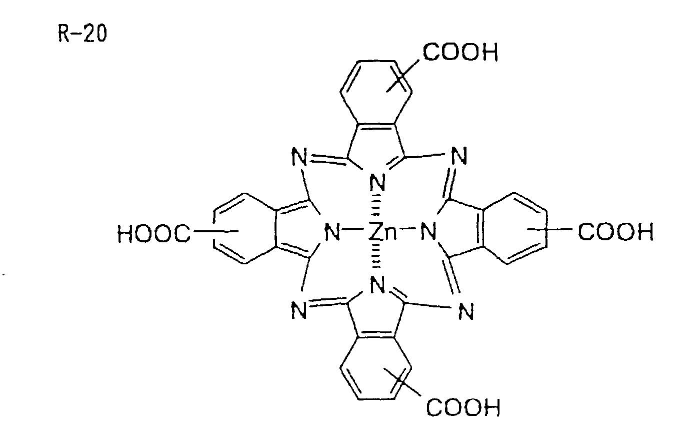

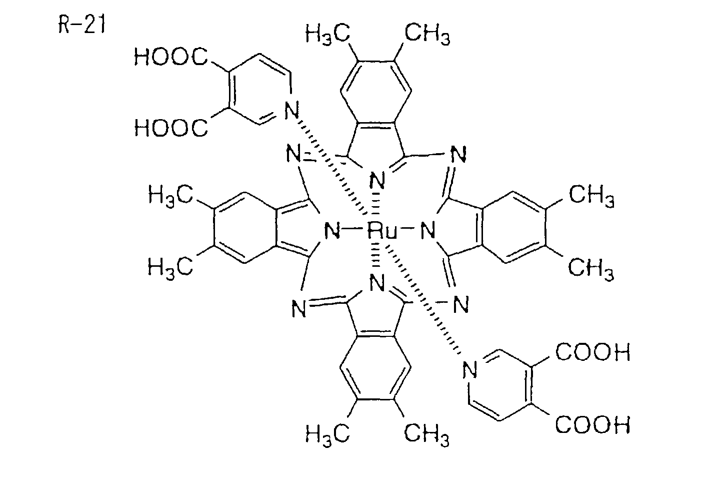

### (b) Methine Dye

The methine dyes which can be used preferably include those described in JP-A-11-35836, JP-A-11-158395, JP-A-11-163378, JP-A-11-214730, JP-A-11-214731, EP 892411, and EP 911841. These methine dyes are synthesized with reference to the teachings of F.M. Harmer, *Heterocyclic Compounds-Cyanine Dyes and Related Compounds,* John Wiley & Sons (1964), D.M. Sturmer, *Heterocyclic Compounds-Special Topics in Heterocyclic Chemistry,* ch. 18, §14, pp. 482-515, John Wiley & Sons (1977), and *Rodd's Chemistry of Carbon Compounds,* 2nd Ed., vol. IV, part B, ch. 15, pp. 369-422, Elsevier Science Publishing Company Inc. (1977), GB Patent 1,077,611, *Ukrainskii Khimicheskii Zhurnal,* vol. 40, No. 3, pp. 253-258, *Dyes and Pigment,* vol. 21, pp. 227-234, and references cited therein.

### (4) Dye Adsorption onto Semiconductor Particles

Adsorption of the dyes onto semiconductor particles is effected by dipping a well-dried work electrode (an electrically conductive support having a particulate semiconductor layer) in a dye solution, which can be embodied by immersion, dip coating, roll coating, air knife coating, etc., or coating the semiconductor layer with a dye solution, which can be embodied by wire bar coating, slide hopper coating, extrusion coating, curtain coating, spin coating, spraying, letterpress printing, offset printing, gravure printing, screen printing, etc. In case of immersion, the dye adsorption may be either at room temperature or under reflux as taught in JP-A-7-249790.

The solvent of the dye solution is selected appropriately according to the solubility of the dye. Solvents of choice include alcohols (e.g., methanol, ethanol, t-butanol and benzyl alcohol), nitriles (e.g., acetonitrile, propionitrile and 3-methoxypropionitrile), nitromethane, halogenated hydrocarbons (e.g., dichloromethane, dichloroethane, chloroform, and chlorobenzene), ethers (e.g., diethyl ether and tetrahydrofuran), dimethyl sulfoxide, amides (e.g., N,N-dimethylformamide and N,N-dimethylacetamide), N-methylpyrrolidone, 1,3-dimethylimidazolidinone, 3-methyloxazolidinone, esters (e.g., ethyl acetate and butyl acetate), carbonic esters (e.g., diethyl carbonate, ethylene carbonate, and propylene carbonate), ketones (e.g., acetone, 2-butanone, and cyclohexanone), hydrocarbons (e.g., hexane, petroleum ether, benzene, and toluene), and mixtures thereof.

As previously mentioned with regard to the formation of the particulate semiconductor layer, extrusion coating and various printing methods are fit for a high viscous dye solution (e.g., 0.01 to 500 Poise), while slide hopper coating, wire bar coating and spin coating are suited for a low viscous dye solution (e.g., 0.1 Poise or lower) to form a uniform film. In this way, an appropriate technique for dye adsorption is to be selected according to such parameters as the viscosity of the dye solution, the coating weight, the kind of the substrate, the speed of application, and the like. Taking the suitability to large-scale production, the time required for dye adsorption after dye application is conveniently as short as possible.

In order to obtain a sufficient sensitizing effect, the dyes are preferably adsorbed in a total amount of 0.01 to 100 mmol per m² of the electrically conductive support and 0.01 to 1 mmol per gram of the semiconductor particles. With too small a total amount of the dyes, the sensitizing effect would be insufficient. If the dyes are used in too large a total amount, the non-adsorbed dyes will float only to lessen the sensitizing effect.

The above-described heat treatment of the semiconductor layer before dye adsorption is favorable for increasing the amount of the dyes adsorbed. Where the heat treatment is conducted, it is preferred that the dyes be quickly adsorbed into the heated semiconductor layer while it is between 40°C and 80°C so as to prevent water from being adsorbed to the semiconductor particles.

A colorless compound may be adsorbed together with the dyes so as to lessen the interaction among dye molecules, such as association. Hydrophobic compounds such as carboxyl-containing steroid compounds (e.g., chenodeoxycholic acid) can be used for this purpose. Ultraviolet absorbers may be adsorbed in combination to prevent deterioration by ultraviolet light.

Because dyes remaining unadsorbed cause disturbances of device performance, they should be washed away immediately after adsorption. Washing is conveniently carried out in a wet washing tank with an organic solvent, such as a polar solvent (e.g., acetonitrile) or an alcohol. If desired, the surface of the semiconductor particles can be treated with an amine after dye adsorption so as to accelerate removal of the unadsorbed dyes. Preferred amines include pyridine, 4-t-butylpyridine, and polyvinylpyridine. The amine can be used as such where it is liquid, or as dissolved in an organic solvent.

### (D) Counter Electrode

In a photo cell using the photoelectric conversion device, the counter electrode functions as a positive electrode. Similar to the electrically conductive support, the counter electrode may be a single layer made up of an electrically conducting agent (counter electrode electrically conductive layer) or a combination of the counter electrode electrically conductive layer and a supporting substrate. Conducting agents of choice for the counter electrode include metals (e.g., platinum, gold, silver, copper, aluminum, magnesium, rhodium, and indium), carbon, and electrically conductive metal oxides (e.g., indium-tin complex oxide and Fluorine-doped tin oxide). Preferred of these conducting agents are platinum, gold, silver, copper, aluminum and magnesium. Suitable counter electrodes include a glass or plastic substrate having the above-described conducting agent applied or deposited thereon.

While not limiting, the counter electrode electrically conductive layer preferably has a thickness of 3 nm to 10 µm. In particular, a metallic counter electrode electrically conductive layer preferably has a thickness of 5 µm or smaller, particularly 5 nm to 3 µm. The surface resistivity of the counter electrode is preferably as low as possible. A preferred surface resistivity of the counter electrode is 80 Ω/square or lower, particularly 20 Ω/square or lower.

Since light should enter the photoelectric conversion device from either one or both of the electrically conductive support and the counter electrode, at least one of the electrically conductive support and the counter electrode must be substantially transparent so that incident light can pass therethrough and reach the photosensitive layer. It is preferred that the electrically conductive support be transparent so that light may be incident upon this side. In this case, it is a preferred embodiment that the counter electrode has light reflecting properties. A glass or plastic substrate having a metal or electrically conductive oxide deposit layer or a metallic thin film can be used as a reflective counter electrode.

The counter electrode is formed either by coating the positive hole-transporting layer with a conducting material by application, plating or vacuum deposition (PVD or CVD) or by sticking a substrate having an electrically conductive layer to the positive hole-transporting layer with its electrically conductive layer inside. It is preferred, as with the case of the electrically conductive support, to use metal leads for decreasing the resistance particularly where the counter electrode is transparent. The above-described particulars as to the material of metal leads, method for making metal leads, reduction in incident light quantity due to metal leads apply to the counter electrode.

### (E) Other Layers

It is a preferred embodiment to previously provide a dense and thin semiconductor layer on the electrically conductive support as an undercoat to prevent a short circuit between the counter electrode and the electrically conductive support. The undercoat preferably comprises an oxide semiconductor, such as TiO₂, SnO₂, Fe₂O₃, WO₃, ZnO, and Nb₂O₅. TiO₂ is still preferred. The undercoat can be formed by, for example, spray pyrolysis as described in *Electrochimi*. *Acta,* vol. 40, pp. 643-652 (1995). A preferred thickness of the undercoat is 5 to 1000 nm, particularly 10 to 500 nm.

If necessary, additional functional layers, such as a protective layer and an antireflection layer, can be formed on the electrically conductive support of the work electrode and/or the counter electrode. Where a plurality of additional layers having the respective functions are to be provided, while they can be formed either simultaneously or successively, simultaneous coating is preferred for productivity. Simultaneous coating is conveniently carried out by a slide hopper method or extrusion coating in view of productivity and uniformity of the film formed. Depending on the material, these functional layers may be provided by vacuum evaporation or press bonding.

### (F) Internal Structure of Photoelectric Conversion Device

As described above, the photoelectric conversion device can have a variety of internal structures in conformity with the end use. Conceivable forms are roughly divided into two types; structures which receive light from both sides and those which receive light from one side. Internal structures of photoelectric conversion devices that are suitably applied to the present invention are shown in Figs. 2 through 9.

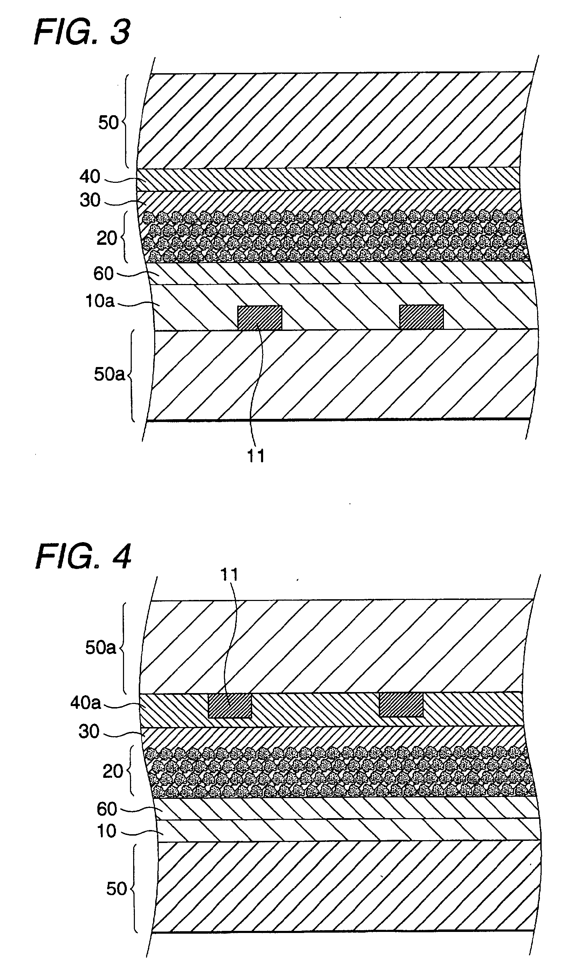

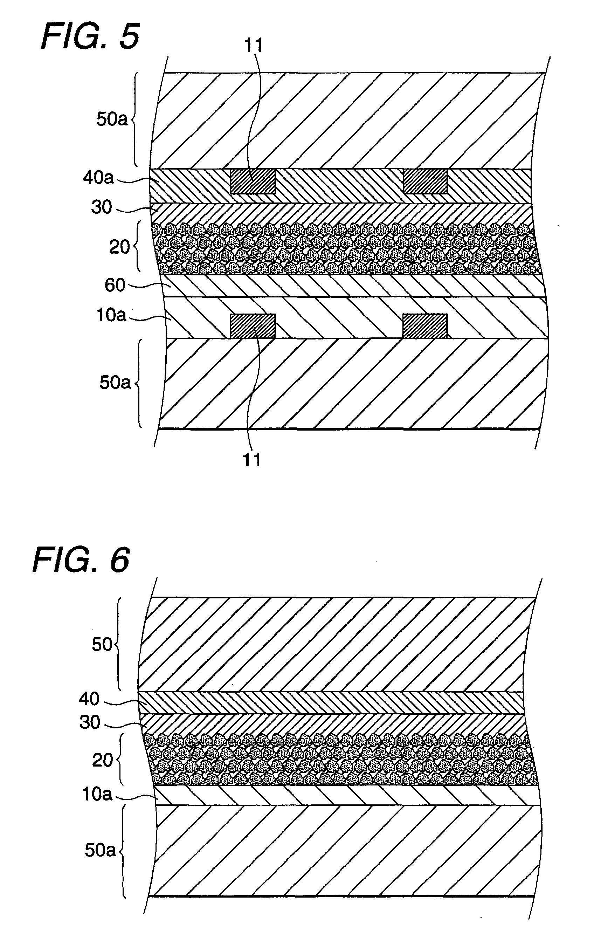

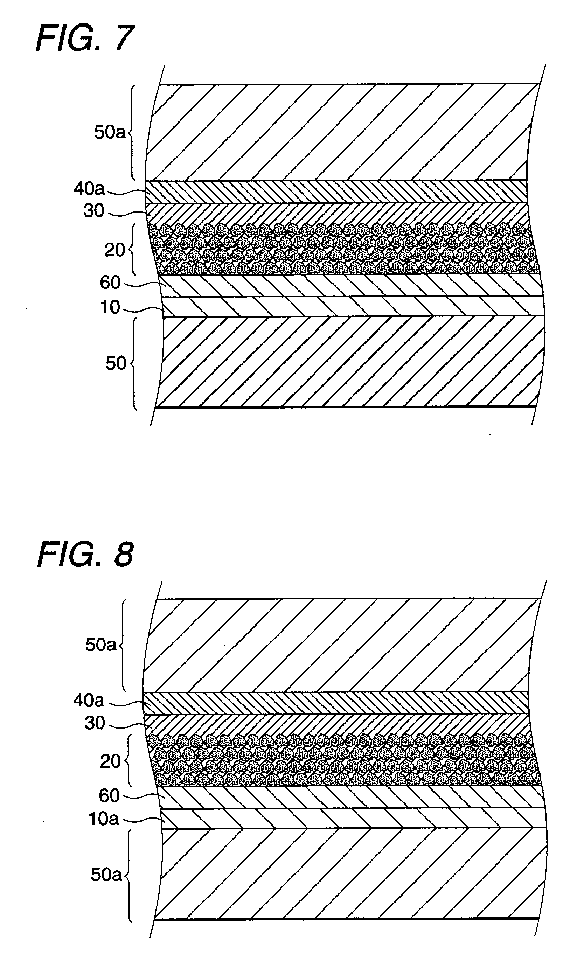

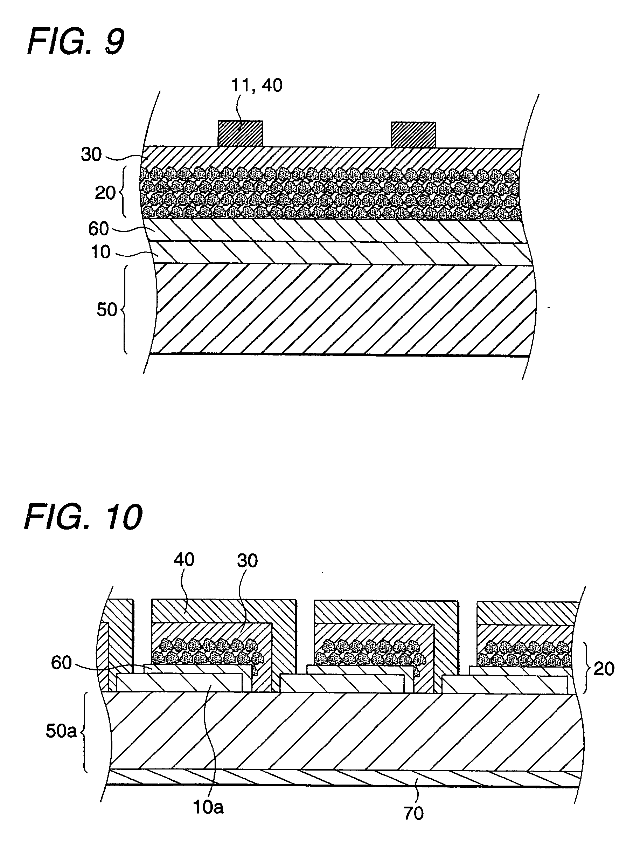

Fig. 2 is a structure made up of a pair of transparent electrically conductive layers (a transparent electrically conductive layer 10a and a transparent counter electrode electrically conductive layer 40a) having sandwiched therebetween a photosensitive layer 20 and a positive hole-transporting layer 30, which allows light to enter from its both sides. Fig. 3 is a structure having, in the order described, a transparent substrate 50a, a metal lead 11 which is provided in parts, a transparent electrically conductive layer 10a, an undercoat 60, a photosensitive layer 20, a positive hole-transporting layer 30, a counter electrode electrically conductive layer 40, and a substrate 50, which allows light to enter from its electrically conductive layer side. Fig. 4 shows a structure having, in the order described, a substrate 50, an electrically conductive layer 10, an undercoat 60, a photosensitive layer 20, a positive hole-transporting layer 30, a transparent counter electrode electrically conductive layer 40a, and a transparent substrate 50a partially having thereon a metal lead 11 with the metal lead 11 inside, which allows light to enter from the counter electrode side. Fig. 5 is a structure having, in the order described, a transparent substrate 50a, a metal lead 11 which is provided in parts, a transparent electrically conductive layer 10a, an undercoat 60, a photosensitive layer 20, a positive hole-transporting layer 30, a transparent counter electrode electrically conductive layer 40a, and another transparent substrate 50a having thereon a metal lead 11 in parts with the metal lead 11 inside, which allows light to enter from both sides thereof. Fig. 6 depicts a structure having, in the order described, a transparent substrate 50a, a transparent electrically conductive layer 10a, a photosensitive layer 20, a positive hole-transporting layer 30, a counter electrode electrically conductive layer 40, and a substrate 50, which allows light to enter from its electrically conductive layer side. Fig. 7 illustrates a structure having, in the order described, a substrate 50, an electrically conductive layer 10, an undercoat 60, a photosensitive layer 20, a positive hole-transporting layer 30, a transparent counter electrode electrically conductive layer 40a, and a transparent substrate 50a, which allows light to enter from the counter electrode side. Fig. 8 shows a structure having, in the order described, a transparent substrate 50a, a transparent electrically conductive layer 10a, an undercoat 60, a photosensitive layer 20, a positive hole-transporting layer 30, a transparent counter electrode electrically conductive layer 40a, and a transparent substrate 50a, which allows light to enter from its both sides. Fig. 9 is a structure having, in the order described, a substrate 50, an electrically conductive layer 10, an undercoat 60, a photosensitive layer 20, a solid positive hole-transporting layer 30, and a counter electrode electrically conductive layer 40 or a metal lead 11 provided in parts, which allows light to enter from the counter electrode side.

### [II] Photo Cell

The photo cell of the present invention is a practical application of the above-described photoelectric conversion device, in which the photoelectric conversion device is designed to work in an external circuit to which it is connected. A solar cell is one embodiment of the photo cell. A photo cell preferably has its sides sealed with a polymer, an adhesive, etc. to prevent deterioration by oxidation or volatilization of the volatile matter contained therein. The external circuit connected to the electrically conductive support and the counter electrode via the respective leads is well known. The solar cell to which the photoelectric conversion device of the invention is applied basically has the same internal structure as the above-described photoelectric conversion device.

The module structures of the solar cell to which the photoelectric conversion device of the invention is applied are then described.

The dye-sensitized solar cell according to the present invention basically has the same module structure as conventional solar cell modules. It generally comprises cells built up on a metallic, ceramic or like substrate and covered with a filling resin or protective glass so that light can enter on the side opposite to the substrate. Where the substrate, on which the cells are provided, is made of a transparent material such as tempered glass, the cells can take in light from the side of the transparent substrate. Known module structures include a superstraight type, a substraight type or potting type or a substrate-integrated type used in amorphous silicon solar cells. A suitable module structure can be chosen appropriately according to the end use, the place of use, or the environment in which it is to be used.

A superstraight or substraight type module typically comprises a pair of supporting substrates one or both of which are transparent and have been subjected to an antireflection surface treatment, having cells interposed therebetween at regular intervals, the cells being connected to each other with a metal lead, flexible wiring, etc. A current collecting electrode is disposed at the outer edge to take out the generated power. In order to protect the cells and to increase the current collection efficiency, various plastic materials, such as ethylene-vinyl acetate copolymer (EVA), selected according to the purpose, can be provided between the substrates and the cells in the form of a film or a filling resin. Where the module is for use in places free from shocks so that there is no need to cover the surface with a rigid material, the surface protective layer may be of a transparent plastic film, or the above-mentioned filling resin is hardened to serve as a protector which can take the place of the substrate on that side. To secure tight seal of the inside and rigidity of the module, the peripheries of the substrates are fixedly sandwiched in a metal frame, and the gaps between the substrates and the frame is sealed with a sealing compound. A solar cell could be constituted even on a curved surface by using flexible materials for the cells themselves, substrates, filling materials and sealing compounds.

Solar cell modules of superstraight type are manufactured by, for example, successively providing a front substrate, fed from a substrate feeder and carried on a belt conveyer, etc., with cells together with a sealing compound, leads for cell connection, back side sealing compound, and the like, putting thereon a back substrate or a back cover, and setting a frame around the peripheries.

Those of substraight type are manufactured by, for example, successively providing a supporting substrate, fed from a substrate feeder and carried on a belt conveyer, etc., with cells together with leads for cell connection, a sealing compound, and the like, putting a front cover thereon, and setting a frame around the peripheries.

Fig. 10 presents an example of a substrate-integrated type module of the device according to the invention. The module structure shown comprises cells formed on a transparent substrate 50a which has on one side thereof a transparent electrically conductive layer 10a, an undercoat 60, a photosensitive layer 20 containing dye-sensitized TiO₂, a positive hole-transporting layer 30, and a metal layer as a counter electrode electrically conductive layer 40. On the other side of the substrate 50a, an antireflection layer 70 is provided. It is preferred to increase the area ratio (the ratio of the area seen from the substrate 50a, i.e., the light incident side) of the photosensitive layer 20 to improve the utilization efficiency of incident light.

Modules of substrate-integrated type shown in Fig. 10 are produced by successively providing a substrate with a transparent electrically conductive layer, a photosensitive layer, a positive hole-transporting layer, and a counter electrode, etc. to build up three-dimensional structures at given intervals by known semiconductor processing techniques, such as selective plating, selective etching, CVD and PVD, or by pattern coating, or by mechanical processing techniques involving the step of forming a layer by coating in a band form, followed by patterning by laser machining, plasma CVM (see *Solar Energy Materials and Solar Cells,* vol. 48, pp. 373-381) or a mechanical means, such as grinding.

Other members used in the solar cell modules and the steps involved in the manufacture of solar cell modules will be described.

The sealing compound is selected from various materials, for example liquid EVA, an EVA film, and a mixture of vinylidene fluoride copolymer and an acrylic resin, in accordance with the purposes, such as improvement on weatherability, electrical insulation, improvement on light collection efficiency, protection of cells (improvement on impact resistance), and the like. Weatherable and moistureproof sealing compounds are convenient for sealing the gaps between the periphery of the module and the frame. A transparent filler may be added to the sealing compound to enhance the strength or to increase light transmission.

The sealing compound is applied on the cells by an appropriate method fit for the physical properties of the compound. For example, a sealing material of film form is applied onto the cells by pressing with a roller or vacuum packaging, followed by heat sealing. A liquid or pasty sealing compound can be applied by roll coating, bar coating, spraying, screen printing, or a like method.

Where a flexible substrate of PET, PEN, etc. is used, a highly productive sealing method comprises unrolling the substrate from a rollstock, building up cells thereon, and applying a sealing layer continuously in the manner described above.

In order to increase power generation efficiency of the module, the substrate on the light incident side (generally tempered glass) is subjected to an antireflection surface treatment, such as laminating or coating with an antireflection coat. Further, incident light utilization efficiency can be increased by grooving or texturing the cell surface.

It is important for obtaining increased power generation efficiency not only that light be took in the inside of the module with little loss but that the light having passed through the photosensitive layer and reached the opposite substrate be reflected and returned to the photosensitive layer. This is achieved by a method comprising mirror polishing the surface of the back substrate and applying Ag, Al, etc. by vacuum evaporation or plating, a method comprising providing the back side of the cell with an alloy layer of Al-Mg, Al-Ti, etc. as a reflecting layer, or a method comprising annealing to have the back side textured.

It is also important for increasing the power generation efficiency to minimize the resistance of intercellular connections thereby to suppress internal voltage drop. The cells are usually connected by wire bonding or with an electrically conductive flexible sheet. In addition, an electrically conductive adhesive tape or an electrically conductive adhesive can be used for achieving both fixing of the cells and electrical connection among the cells, or an electrically conductive hot-melt adhesive can be patternwise applied to desired sites.

Solar cells using a flexible substrate such as a polymer film are produced by successively forming cells on the substrate, being unrolled and transferred, in the manner described above, cutting to size, and sealing the periphery with a flexible and moistureproof material. A module structure called "SCAF" (see *Solar Energy Materials and Solar Cells,* vol. 48, pp. 383-391) is also applicable. Solar cells having a flexible substrate can be used as adhered to curved glass, etc.

Thus, solar cells having various configurations and functions can be manufactured in agreement with the purpose of use and the environment of use.

### EXAMPLE

The present invention will now be illustrated in greater detail with reference to Examples. Unless otherwise noted, all the percents are by weight.

### 1) Preparation of titanium dioxide dispersion

Titanium tetraisopropoxide (142.1 g) and 149.2 g of triethanolamine were mixed in a dry box at room temperature. After being allowed to stand for 2 hours in the dry box, the mixture was diluted with distilled water to make 1000 ml. A 100 ml portion of the resulting mixture was mixed with distilled water to which 2.85 ml of acetic acid had been added to make 100 ml. The mixture was heated in a closed container at 100°C for 24 hours into a white gel. The temperature was raised to 140°C, at which the mixture was further heated for 72 hours. After cooling to room temperature, the supernatant liquor was removed to obtain a pale reddish brown precipitate. The wet precipitate weighed 33 g. To the precipitate was added 1.0 g of polyethylene glycol having a molecular weight of 500,000, and the mixture was kneaded in a kneading machine for 20 minutes to prepare a titanium dioxide dispersion having a concentration of 12%. The titanium dioxide particles as dispersed had an average particle size of about 16 nm.

### 2) Preparation of semiconductor electrode

### 2-1) Particulate semiconductor electrode S-1

A transparent electrically conductive glass sheet having an Fluorine-doped tin oxide coat (available from Nippon Sheet Glass Co., Ltd.; surface resistivity: 10 Ω/square) was used as an electrically conductive support. An adhesive tape was stuck to one end over a 3 mm width from the edge of the electrically conductive side as a spacer, and the TiO₂ dispersion prepared in (1) above was applied thereon with a glass rod. The adhesive tape was stripped, and the applied dispersion was air dried and baked in an electric muffle furnace (Model FP-32, manufactured by Yamato Kagaku) at 450°C for 30 minutes. The coating weight and thickness of the TiO₂ layer thus formed were 8.9 g/m² and 5.7µm, respectively. The BET specific surface area of the TiO₂ layer was 49 m²/g. The resulting electrode was designated electrode S-1.

### 2-2) Particulate semiconductor electrode S-2, S-3 and S-4

A 5 mm width from one edge of the electrically conductive side of the same electrically conductive glass as used in electrode S-1 was masked with glass, and a titanium dioxide thin film having a thickness of 60 nm was formed on the unmasked area as an undercoat by spray pyrolysis according to *Electrochimi. Acta*, vol. 40, pp. 643-652 (1995). Then, a titanium dioxide layer having a thickness of 5.5 µm and a weight of 9.0 g/m² was formed thereon in the same manner as for electrode S-1. The BET specific surface area was 51 m²/g. The resulting semiconductor electrode was designated electrode S-2.

Electrodes S-3 and S-4 were prepared in the same manner as for electrode S-2, except for changing the coating weight of titanium dioxide as shown in Table 1 below.

### 2-3) Particulate semiconductor electrode S-5 (based on J. Phys. D: Appl. Phys., vol. 31, pp. 1492-1496 (1998))

Distilled water (5 ml) was slowly added dropwise to a mixture of 1 ml of titanium tetrapropoxide, 5 ml of glacial acetic acid, and 15 ml of isopropyl alcohol while vigorously stirring. The resulting white gel dispersion was applied on the same electrically conductive glass as used in electrode S-1 (1.5 cm x 2.0 cm) located on a hot plate heated to 125°C, and allowed to stand for several minutes. The electrode was fired at 430°C for 10 minutes in the same electric furnace as used for electrode S-1. After clearing chips of the coating film off the electrode, the same white gel dispersion was again applied to the electrode heated at 125°C and fired at 430°C for 10 minutes. The application of the dispersion, firing, and removal of chips were repeated 40 times to obtain an electrode having a TiO₂ layer having a thickness of 5 µm and weight of 7.9 g/m². The BET specific surface area of the TiO₂ layer was 15 m²/g.

### 2-4) Non-porous semiconductor electrode S-6 for comparison (based on J. Appl. Phys., vol. 80, No. 8, pp. 4749-4754 (1996))

The same electrically conductive glass as used in electrode S-1 was heated to 500°C and sprayed with a mixture of a 0.2 mol/1 ethanolic solution of titanium tetraisopropoxide and a 0.4 mol/1 ethanolic solution of acetylacetone to obtain semiconductor electrode S-6 having a TiO₂ layer thickness of 100 nm (coating weight: 0.3 g/m²; BET specific surface area: 0.1 m²/g).

The semiconductor electrodes prepared are shown in Table 1.

**TABLE 1**

| Electrode | BET Specific Surface Area (m²/g) | Undercoat | Coating Weight (g/m²) |
|---|---|---|---|
| S-1 | 49 | not provided | 8.9 |
| S-2 | 51 | provided | 9 |
| S-3 | 52 | provided | 4 |
| S-4 | 47 | provided | 16 |
| S-5 | 15 | not provided | 7.9 |
| S-6 | 0.1 | not provided | 0.3 |

### 3) Preparation of dye-sensitized TiO₂ electrode

### 3-1) Dye-sensitized electrode D-1 to D-6

Electrode S-1 was fired in an electric muffle furnace Model FP-32 (Yamato Kagaku) at 450°C for 30 minutes. The electrode S-1 was taken out of the furnace and immersed in an ethanolic solution of 3 x 10⁻⁴ mol/l of dye R-1 at room temperature for 12 hours. The dyed semiconductor layer was washed with acetonitrile, dried spontaneously, and cut to 10 mm lengths to make 10 mm wide and 25 mm long electrodes (designated electrode D-1).

Similarly, dye-sensitized electrodes D-2 to D-6 were prepared by using the electrodes and dyes shown in Table 2 below. Dye M-1 used in D-4 has the following formula:

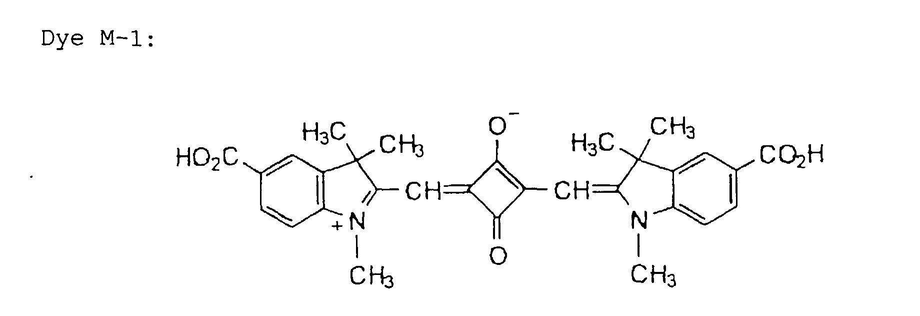

### 3-2) Dye-sensitized electrode D-7 (based on J. Phy. D: Appl. Phys., vol. 31, pp. 1492-1496 (1998))

Electrode S-5 was washed by dipping successively in aqueous ammonia and distilled water and then washed with acetone heated to 50°C for 10 minutes. The washed electrode was immersed in a solution of 25 mg of dye R-1 in 50 ml of ethanol heated to 70°C for 2 minutes. The electrode as immersed in the ethanolic dye solution was allowed to cool to room temperature over a 45 minute period. The electrode thus having the dye adsorbed was washed with distilled water and dried in a nitrogen atmosphere in a dark place to obtain dye-sensitized electrode D-7.

### 3-3) Comparative dye-sensitized electrodes D-8 and D-9 (based on J. Appl. Phys., vol. 80, No. 8, pp. 4749-4754 (1996))

Electrode S-6 was fired in an electric muffle furnace Model FP-32 (Yamato Kagaku) at 450°C for 30 minutes. The electrode S-6 was taken out of the furnace and immersed in a 1 x 10⁻⁵ mol/l ethanolic solution of Ru(II)LL' (NCS) (L: 2,2":6',2"-terpyridine-4'-phosphonic acid; L': 4,4'-dimethyl-2,2'-bipyridine; name of the dye: Z105) at room temperature for 12 hours. The dyed semiconductor layer was washed with acetonitrile, dried spontaneously, and cut to make a 10 mm wide and 25 mm long electrode (designated dye-sensitized electrode D-8).

Similarly dye-sensitized electrode D-9 was prepared by using electrode S-6 and dye R-1.

**TABLE 2**

| Dye-sensitized Electrode | Semiconductor Electrode | Dye |
|---|---|---|
| D-1 | S-1 | R-1 |
| D-2 | S-2 | R-1 |
| D-3 | S-2 | R-10 |
| D-4 | S-2 | M-1 |
| D-5 | S-3 | R-1 |
| D-6 | S-4 | R-1 |
| D-7 | S-5 | R-1 |
| D-8 | S-6 | Z105 |
| D-9 | S-6 | R-1 |

### 4) Formation of positive hole-transporting layer

### 4-1) Preparation of electrodes P-1 to P-14 with positive hole-transporting layer

In 30 ml of acetone were added 0.2 g of CuI and 0.5 g of KI, followed by thoroughly stirring until the CuI dissolved to prepare reaction solution (A). Reaction solution (A) was put in an electrolytic cell of a potentiostat/galvanostat HA-305 (supplied by Hokuto Denko K.K.), and dye-sensitized electrode D-1 (the dye adsorption area: 1 cm²) and a platinum plate were immersed therein face to face as a work electrode and a counter electrode, respectively. Constant-current electrolysis was carried out at a current density of 30 mA/cm² for 15 seconds to induce oxidation on the work electrode to obtain a CuI precipitate. The CuI-deposited work electrode was allowed to stand in air for 2 hours to obtain electrode P-1 comprising electrode D-1 having formed thereon a positive hole-transporting layer of CuI.

Similarly, electrodes P-2 to P-14 having a positive hole-transporting layer of CuI were prepared by using each of the dye-sensitized electrodes shown in Table 3 at the current density shown in Table 3. Electrodes P-13 and P-14 are for comparison.

**TABLE 3**

| Electrode with Positive hole-transporting Layer | Dye-sensitized Electrode | Current Density (mA/cm²) |
|---|---|---|
| P-1 | D-1 | 30 |
| P-2 | D-2 | 30 |
| P-3 | D-2 | 5 |
| P-4 | D-2 | 15 |
| P-5 | D-2 | 70 |
| P-6 | D-2 | 110 |
| P-7 | D-2 | 150 |
| P-8 | D-3 | 30 |
| P-9 | D-4 | 30 |
| P-10 | D-5 | 30 |
| P-11 | D-6 | 30 |
| P-12 | D-7 | 30 |
| P-13 | D-8 | 30 |
| P-14 | D-9 | 30 |

### 4-2) Preparation of electrodes P-15 to P-17 with positive hole-transporting layer

Controlled potential electrolysis was carried out by using the same reaction solution (solution (A)), the same work electrode (electrode D-1), and the same apparatus as used in the preparation of electrode P-1 for 5 minutes to obtain electrode P-15 with positive hole-transporting layer. A silver/silver chloride electrode was used as a reference electrode, and the potential was set at 2 V with reference to the reference electrode. For comparison, electrodes P-16 and P-17 were prepared similarly by using comparative dye-sensitized electrodes D-8 and D-9, respectively.

### 4-3) Preparation of electrodes P-18 and P-19 with positive hole-transporting layer (based on J. Phys. D: Appl. Phys., vol. 31, pp. 1492-1496 (1998))

Dye-sensitized electrode D-1 was put on a hot plate at 125°C in a nitrogen atmosphere, and an anhydrous acetonitrile solution saturated with CuI was slowly applied thereon while vaporizing acetonitrile until the surface resistivity of the electrode became 50 Ω/square. After completion of application, the electrode was left to stand on the hot plate for 2 minutes to obtain comparative electrode P-18 with positive hole-transporting layer. Similarly, comparative electrode P-19 with positive hole-transporting layer was prepared by using dye-sensitized electrode D-7.

### 4-4) Preparation of electrodes P-20 and P-21 with positive hole-transporting layer (based on Chem. Mater., vol. 10, pp. 1501-1509 (1998))

Comparative dye-sensitized electrode D-8 was immersed in an ethanolic solution of KSCN and Cu(BF₄)₂·4H₂O under conditions of -0.1 to -0.2 V with reference to SCE to obtain comparative electrode P-20 having a positive hole-transporting layer of CuSCN. Similarly, electrode P-21 with positive hole-transporting layer according to the present invention was prepared by using dye-sensitized electrode D-1.

### 4-5) Preparation of electrode P-22 with positive hole-transporting layer (based on Nature, vol. 395, pp. 583-585 (Oct. 8, 1998))

Dye-sensitized electrode D-1 was spin coated with 30 µl of a chlorobenzene/acetonitrile (100/5 by volume) solution containing 0.17 M of 2,2',7,7'-tetrakis(N,N-di-p-methoxyphenylamine)-9,9'-spirofluorene, 0.33 mM of tris(4-bromophenyl)aluminum hexachloroantimonate, and 15 mM of Li[(CF₃SO₂)₂N] at 1000 rpm for 60 seconds. The coating layer was dried under reduced pressure at room temperature. Gold was deposited on the coated electrode by vacuum evaporation to prepare comparative electrode P-22 with positive hole-transporting layer.

### 4-6) Method A (controlled potential electrodeposition under irradiation)

### 4-6-1) Preparation of electrode P-23 with positive hole-transporting layer

In 30 ml of acetone were added 0.4 g of CuI and 0.5 g of KI, followed by thorough stirring until the CuI dissolved to prepare reaction solution (B). A coulometer (bipolar coulometer HF-202D) was connected to a potentiostat/galvanostat HA-305 (supplied by Hokuto Denko K.K.) to set up an electrolysis apparatus. Dye-sensitized electrode D-2 (the dye adsorption area: 1 cm²) and a platinum plate were immersed face to face in reaction solution (B) as a work electrode and a counter electrode, respectively. As a reference electrode, an Ag/AgCl electrode was used. The potential was set at 1 V with reference to the reference electrode. The back side (glass substrate side) of the work electrode was irradiated with light of a halogen lamp (150 W halogen lamp PSM-11520, supplied by Nicon Corp.). It was observed that the electric current which had been 0.8 mA/cm² before irradiation greatly increased to 14 mA/cm² on starting irradiation. Under these conditions, controlled potential electrolysis was carried out by passing 1.5 C/cm² of electricity, whereby CuI was deposited on the work electrode. The CuI-deposited electrode was left to stand in air for 2 hours to obtain electrode P-23 comprising electrode D-2 having formed thereon a positive hole-transporting layer of CuI.

### 4-6-2) Preparation of electrode P-24 with positive hole-transporting layer

In 30 ml of acetone were added 0.4 g of CuI, 0.05 g of CuSCN, and 0.5 g of KI, and the mixture was thoroughly stirred to prepare reaction solution (C). Electrode P-24 comprising electrode D-2 having formed thereon a positive hole-transporting layer of CuI and CuSCN was obtained in the same manner as for electrode P-23, except for using reaction solution (C) in place of reaction solution (B).

### 4-6-3) Preparation of electrodes P-25, P-26 and P-27 with positive hole-transporting layer

Electrodes P-25, P-26 and P-27 each having a positive hole-transporting layer were prepared in the same manner as for electrode P-23, except for using dye-sensitized electrode D-1, D-3, or D-4, respectively.

### 4-7) Method B (constant-current electrodeposition under irradiation)

Constant-current electrolysis was carried out by using the same reaction solution (solution (B)) and the same apparatus as in the preparation of electrode P-23 at a constant current density of 25 mA/cm² to pass 1.5 C/cm² of electricity while irradiating the back side of the work electrode (electrode D-2) with light in the same manner as in the preparation of electrode P-23. The CuI-deposited electrode was allowed to stand in air for 2 hours to obtain electrode P-28 comprising electrode D-2 having formed thereon a positive hole-transporting layer of CuI.

### 4-8) Method C (controlled potential electrodeposition with no irradiation)

Controlled potential electrolysis was carried out in the same manner as in the preparation of electrode P-23, except that the work electrode was not irradiated with light. As a result, CuI was not deposited on the work electrode. The resulting electrode was designated electrode P-29.

### 4-9) Method D (constant-current electrodeposition with no irradiation)

Constant-current electrolysis was carried out by using dye-sensitized electrode D-1 as a work electrode in the same manner as in method B, except that the work electrode was not irradiated with light. The CuI-deposited electrode was allowed to stand in air for 2 hours to obtain electrode P-30 comprising electrode D-1 having formed thereon a positive hole-transporting layer of CuI.

### 4-10) Method E (controlled potential electrodeposition based on Chem. Mater., vol. 10, pp. 1501-1509 (1998))

Dye-sensitized electrode D-1 was immersed in an ethanolic solution containing KSCN and Cu(BF₄)₂·4H₂O (reaction solution (D)) to form a CuSCN deposit layer under conditions of -0.1 to -0.2 V with reference to SCE to obtain electrode P-31 having a positive hole-transporting layer.

### 5) Preparation of photo cell

Each of the resulting electrodes having a positive hole-transporting layer (P-1 to P-31) and a 1 cm wide and 2.5 cm long platinum-deposited glass substrate (glass substrate thickness: 1.1 mm; platinum deposit layer thickness: 1 µm) were brought into contact and fixed with clips with the positive hole-transporting layer and the Pt deposit layer facing each other to make a photo cell having the basic structure shown in Fig. 1, which was composed of a glass plate 50a, an electrically conductive layer 10a with/without a TiO₂ undercoat 60, a dye-sensitized TiO₂ electrode layer 20, a positive hole-transporting layer 30, and a counter electrode layer 40 in this order.

For comparison, photo cell A was prepared as follows. Electrode A (TiO₂ electrode sensitized with dye R-6; 1 cm x 2.5 cm) was brought into contact with Pt-deposited glass of the same size. An electrolytic solution (0.05 mol/1 of iodine and 0.5 mol/1 of lithium iodide in acetonitrile/3-methyl-2-oxazolidinone (90/10 by volume)) was penetrated into the gap between the two glass substrates by capillarity.

The relationship between designated photo cells and the used electrodes with positive hole-transporting layer is shown in Table 4 and Table 5.

### 6) Measurement of photoelectric conversion efficiency and shortage ratio

The electrically conductive glass and the counter electrode layer of the photo cell were connected by means of an alligator clip, and the cell was irradiated with pseudo-sunlight having an intensity of 100 mW/cm² which was created by cutting light from a 500 W xenon lamp (produced by Ushio Inc.) through a spectral filter (AM1.5 Filter available from Oriel). The generated electricity was recorded with a Keithley electrometer (Model SMU238). The conversion efficiency (η, %) of the photo cell immediately after preparation and after 24-hour standing as calculated from the quantity of generated electricity and the ratio of shortages encountered in production of 50 cells are shown in Table 4 and Table 5 below.

**TABLE 4**

| Example No. | Electrode with Positive hole-transporting Layer | Conversion Efficiency (%) | | Shortage Ratio (%) |
|---|---|---|---|---|
| | | Immediately after Preparation | after 24-hour Standing | |
| 1 | P-1 | 1.14 | 1.14 | 65 |
| 2 | P-2 | 1.21 | 1.2 | 0 |
| 3 | P-3 | 0.54 | 0.53 | 0 |
| 4 | P-4 | 0.97 | 0.98 | 0 |
| 5 | P-5 | 0.89 | 0.89 | 0 |
| 6 | P-6 | 0.61 | 0.61 | 0 |
| 7 | P-7 | 0.62 | 0.62 | 0 |
| 8 | P-8 | 0.92 | 0.92 | 0 |
| 9 | P-9 | 0.5 | 0.5 | 0 |
| 10 | P-10 | 0.5 | 0.49 | 0 |
| 11 | P-11 | 1.19 | 1.15 | 0 |
| 12 | P-12 | 0.55 | 0.53 | 63 |
| 13 | P-15 | 0.24 | 0.24 | 36 |
| 14 | P-21 | 0.13 | 0.13 | 34 |

| Comparative Example No. | Electrode with Positive Hole Transporting Layer | Conversion Efficiency (%) | | Shortage Ratio (%) |
|---|---|---|---|---|
| | | Immediately after Preparation | after 24-hour Standing | |
| 1 | P-18 | 0.3 | 0.03 | 85 |
| 2 | P-19 | 0.45 | 0.03 | 88 |
| 3 | P-13 | 0.062 | 0.058 | 0 |
| 4 | P-14 | 0.069 | 0.062 | 0 |
| 5 | P-16 | 0.015 | 0.014 | 0 |
| 6 | P-17 | 0.018 | 0.018 | 0 |
| 7 | P-20 | 0.042 | 0.025 | 0 |
| 8 | P-22 | 0.18 | 0.09 | 19 |
| 9 | Photo cell A | 3.5 | 0.03 | 0 |

It is seen that the photo cells of Examples are less susceptible to deterioration with time than Comparative Examples 1 and 3. Compared with Comparative Examples 2 and 4, the photo cells of the Examples show smaller reduction in photoelectric conversion efficiency from the wet type photo cell (Comparative Example 9) and undergo less deterioration with time.

**TABLE 5**

| Example No. | Electrode with Positive hole-transporting Layer | Dye-sensitized Electrode | Electrolytic Reaction Solution | Electrolysis Method | Conversion Efficiency (%) | | Shortage Ratio (%) |
|---|---|---|---|---|---|---|---|
| | | | | | Immediately after preparation | after 24-hour Standing | |
| 15 | P-23 | D-2 | B | A | 2.1 | 2.0 | 0 |
| 16 | P-24 | D-2 | C | A | 1.7 | 1.7 | 0 |
| 17 | P-25 | D-1 | B | A | 1.8 | 1.8 | 39 |
| 18 | P-26 | D-3 | B | A | 1.7 | 1.7 | 0 |
| 19 | P.27 | D-4 | B | A | 1.5 | 1.5 | 0 |
| 20 | P-28 | D-2 | B | B | 2.0 | 1.9 | 0 |

| Comparative Example No. | Electrode with Positive hole-transporting Layer | Dye-sensitized Electrode | Electrolytic Reaction Solution | Electrolysis Method | Conversion Efficiency (%) | | Shortage Ratio (%) |
|---|---|---|---|---|---|---|---|
| | | | | | Immediately after preparation | after 24-hour Standing | |
| 10 | P-29 | D-1 | B | C | 0.0 | - | 60 |
| 11 | P-30 | D-1 | B | D | 1.2 | 0.7 | 66 |
| 12 | P-31 | D-1 | D | E | 0.06 | - | 40 |

It is apparent from the results in Table 5 that the photoelectric conversion devices according to the present invention exhibit superior photoelectric characteristics and durability of the photo cells, and undergo fewer shortages as compared with the comparative ones.

The photoelectric conversion device according to the present invention has a high photoelectric conversion efficiency, has a low shortage ratio and is less susceptible to deterioration of characteristics with time. A photo cell comprising the photoelectric conversion device of the invention is extremely effective as a solar cell.

## Claims

1. A photoelectric conversion device comprising:
an electrically conductive support;
a photosensitive layer containing a semiconductor having a dye adsorbed thereby;
a positive hole-transporting layer containing a positive hole-transporting material; and
a counter electrode,
wherein said positive hole-transporting layer is prepared by electrolysis.

2. The photoelectric conversion device according to claim 1, wherein said semiconductor is a porous semiconductor.

3. The photoelectric conversion device according to claim 1 or 2, wherein said electrolysis is a method of forming said positive hole-transporting layer on said photosensitive layer by electrolysis while irradiating said semiconductor having a dye adsorbed thereby with light

4. The photoelectric conversion device according to claim 3, wherein said light has a wavelength at which said dye shows absorption.

5. The photoelectric conversion device according to claim 3 or 4, wherein said irradiating is from the side of said electrically conductive support.

6. The photoelectric conversion device according to any one of claims 1 to 5, wherein said electrolysis is constant-current electrolysis.

7. The photoelectric conversion device according to any one of claims 1 to 5, wherein said electrolysis is controlled potential electrolysis.

8. The photoelectric conversion device according to any one of claims 1 to 7, wherein the potential of said electrolysis is -2 to 15 V with reference to a silver/silver chloride reference electrode.

9. The photoelectric conversion device according to any one of claims 1 to 8, wherein said electrolysis is at a current density of 0.1 to 500 mA/cm².

10. The photoelectric conversion device according to any one of claims 1 to 9, wherein said positive hole-transporting material mainly contains a p-type semiconductor.

11. The photoelectric conversion device according to claim 10, wherein said p-type semiconductor has a band gap of 2 eV or more.

12. The photoelectric conversion device according to claim 10 or 11, wherein said p-type semiconductor has an ionization potential of 4.5 to 5.5 eV.

13. The photoelectric conversion device according to any one of claims 10 to 12, wherein said p-type semiconductor is a compound semiconductor containing monovalent copper.

14. The photoelectric conversion device according to claim 13, wherein said compound semiconductor containing monovalent copper contains at least one of CuI and CuSCN.

15. The photoelectric conversion device according to any one of claims 1 to 14, wherein said semiconductor of said photosensitive layer has a specific surface area of 1 to 150 m²/g.

16. The photoelectric conversion device according to any one of claims 1 to 14, wherein said semiconductor of said photosensitive layer has a specific surface area of 20 to 100 m²/g.

17. The photoelectric conversion device according to any one of claims 1 to 16, which has an undercoat containing an oxide semiconductor between said electrically conductive support and said photosensitive layer.

18. The photoelectric conversion device according to claim 17, wherein said oxide semiconductor is a titanium dioxide.

19. The photoelectric conversion device according to any one of claims 1 to 18, wherein said dye is a ruthenium complex dye or a methine dye.

20. The photoelectric conversion device according to any one of claims 1 to 19, wherein said semiconductor of said photosensitive layer is constituted by titanium dioxide particles.

21. A photo cell comprising the photoelectric conversion device according to any one of claims 1 to 20.

22. A solar cell module comprising the photoelectric conversion device according to any one of claims 1 to 20.

23. A method for producing a photoelectric conversion device comprising an electrically conductive support, a photosensitive layer comprising a semiconductor having a dye adsorbed thereby, a positive hole-transporting layer comprising a positive hole-transporting material, and a counter electrode, which method comprises forming said positive hole-transporting layer on said photosensitive layer by electrolysis while irradiating said photosensitive layer with light.
